(19) Europäisches Patentamt
European Patent Office
Office européen des brevets

(11) Veröffentlichungsnummer: **0 241 754**
**B1**

(12) **EUROPÄISCHE PATENTSCHRIFT**

(45) Veröffentlichungstag der Patentschrift: **16.05.90**

(21) Anmeldenummer: **87104147.1**

(22) Anmeldetag: **20.03.87**

(51) Int. Cl.[5]: **C23C 18/26,** C23C 18/28, C23C 18/30, C23C 18/32, C23C 18/38, C25D 5/56, H05K 3/00

# (54) Verfahren zur haftfesten Metallisierung von Polyetherimid.

(30) Priorität: **14.04.86 DE 3612822**

(43) Veröffentlichungstag der Anmeldung: **21.10.87 Patentblatt 87/43**

(45) Bekanntmachung des Hinweises auf die Patenterteilung: **16.05.90 Patentblatt 90/20**

(84) Benannte Vertragsstaaten: **BE CH DE ES FR GB IT LI LU NL SE**

(56) Entgegenhaltungen:
**EP-A- 0 131 195**
**EP-A- 0 139 090**
**EP-A- 0 156 120**

**Kunststoff-Kompendium, A. Franck, K. Biederbick, S. 188-189 (1984), Vogel-Buchverlag, Würzburg**

(73) Patentinhaber: **SCHERING AKTIENGESELLSCHAFT Berlin und Bergkamen, Müllerstrasse 170/178 Postfach 65 03 11, D-1000 Berlin 65(DE)**

(72) Erfinder: **Mahlkow, Hartmut, Handjerystrasse 85, D-1000 Berlin 41(DE)**
Erfinder: **Strache, Waltraud, Lübener Weg 35, D-1000 Berlin 51(DE)**

**EP 0 241 754 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft ein Verfahren zur haftfesten Metallisierung von Polyetherimid durch Vorbehandlung des Polyetherimids und anschließende Aktivierung sowie chemische und gegebenenfalls galvanische Metallabscheidung.

Die Herstellung von Polyamid beziehungsweise Polyetherimid-Metall-Verbund-Werkstoffen ist an sich bereits bekannt (EP-A1 0 139 090).

Sie erfolgt durch Vorbehandlung mit einer wässrigen Lösung enthaltend Alkalihydroxid gegebenenfalls in Mischung mit einem organischen Lösungsmittel, welche zusätzlich ein zweiwertiges Metall in Form seiner Verbindungen enthält.

Auch die Metallisierung von Polyethermid ist an sich bekannt. Sie erfolgt nach den für die Kunststoffmetallisierung bekannten Verfahren durch Ätzung, Aktivierung und nachfolgende chemische und galvanische Metallisierung. Als Ätzmittel finden in der Regel Chromsäure- und/oder Chromsäure-Schwefelsäurelösungen Verwendung, worauf mittels eines sauren Aktivators auf Palladiumbasis aktiviert und anschließend chemisch verkupfert wird, um eine erste Leitschicht auf dem Substrat zu erhalten, die dann galvanisch verstärkt und mit bekannten Techniken für den Einsatz in der Elektronik strukturiert wird.

Ein Nachteil dieser Verfahren besteht darin, daß die Chromsäure und/oder Schwefelsäure tief in das Substratmaterial eindringt, was zu Korrosionserscheinungen der Metallauflage durch die an die Oberfläche zurückdiffundierenden Säuren führen kann.

Ein weiterer Nachteil ist die Umweltbelastung durch Chromsäure, die eine Behandlung des Abwassers unumgänglich macht, sowie die durch die genannten Ätzmittel bewirkte starke Aufrauhung der Oberflächen, die deren Verwendung für Strukturen mit sehr geringer Leiterzugbreite entgegensteht.

Aufgabe der vorliegenden Erfindung ist die Schaffung eines Verfahrens, welches sowohl eine schonende Vorbehandlung von Polyetherimid als auch dessen haftfeste Metallisierung erlaubt.

Diese Aufgabe wird erfindungsgemäß durch ein Verfahren der eingangs genannten Art dadurch gelöst, daß das Polyetherimid mit einer Lösung bestehend aus einem alkalihydroxidhaltigen organischen Lösungsmittel, gegebenenfalls Wasser enthaltend, vorbehandelt wird.

Besondere Ausführungsformen dieses Verfahrens sind in den Unteransprüchen gekennzeichnet. Als organische Lösungsmittel können ein Alkohol, ein Keton, ein Ester, ein mehrwertiger Alkohol, ein Ester eines mehrwertigen Alkohols, ein aromatischer Alkohol, ein aromatisches Keton, ein aromatischer Ester, ein heterocyclisches organisches Lösungsmittel, oder deren Mischungen verwendet werden. Beispielsweise sind hiervon folgende zu nennen Methanol, Äthanol, Propanole, Butanole, Octanole, Cyclohexanole, Äthylenglykol, Diäthylenglykol, Dibutyläther, Anisol, Ethylenglykolmonomethylether, Diäthylenglykolether, Dioxan, Tetrahydrofuran, Aceton, Butanon, Cyclohexanin, Essigsäureäthylester, Butylacetat, Glykolester, Dimethylformamid, Dimethylsulfoxid und Methylpyrrolidon.

Als Alkyalihydroxide finden Lithiumhydroxid, Natriumhydroxid und Kaliumhydroxid oder Kombinationen der Hydroxide Verwendung.

Als Polyetherimid sollen amorphe thermoplastische Kunststoffe der allgemeinen Formel

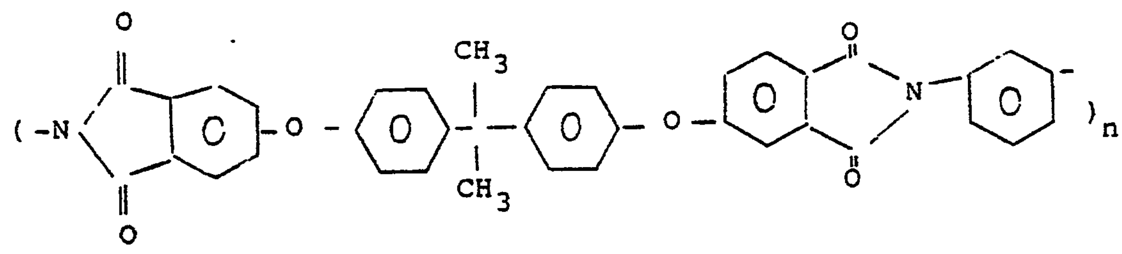

verstanden werden, die in an sich bekannter Weise hergestellt werden können.

Die Vorbehandlung des Polyetherimids nach dem erfindungsgemäßen Verfahren findet nur auf der Oberfläche des Kunststoffes statt. Etwa in die Tiefe diffundiertes Lösungsmittel kann vorteilhafterweise während eines nachfolgenden Tempervorganges leicht ausgetrieben werden.

Eine derart vorbehandelte Oberfläche läßt keinen, auch nicht unter dem Mikroskop sichtbaren Angriff erkennen.

In Folge wird die Oberfläche mit einem alkalisch-wässrigen Palladiumaktivator aktiviert. Das Palladium ist dabei an einem Komplexbildner gebunden und liegt in ionogener Form vor. Die Palladiumionen sind fest an der Polyetherimidoberfläche absorbiert und werden auch bei langen Spülprozessen nicht abgespült.

Nach der Reduktion des Palladiums in geeigneten Reduktionsmitteln, zum Beispiel Dimethylaminboran, wird die Oberfläche nach üblichen Verfahren chemisch metallisiert. Im Falle von Leiterplatten wird Kupfer der Vorzug gegeben, da die Leitfähigkeit bei einer Leiterplatte im Vordergrund steht.

Die chemisch verkupferte Platte wird nun einer Temperung bei 100°C unterworfen, um gegebenenfalls Wasser und/oder Lösungsmittel auszutreiben.

Im Anschluß an die galvanische Verstärkung im sauren Kupferbad auf mindestens 5 µm Kupferschichtdicke, kann die Platte nach den üblichen Strukturierungsverfahren bearbeitet werden.

Die erfindungsgemäß hergestellten Polyetherimid-Metall-Verbundstoffe sind von großer Stabilität, die Haftfestigkeit der Metallschichten ungewöhnlich hoch. Diese Werkstoffe finden Verwendung für Formteile, vorzugsweise als Leiterplatten in der Elektronik.

Die folgenden Beispiele dienen zur Erläuterung der Erfindung.

BEISPIEL 1

Eine gespritzte Platte aus Polyetherimid verstärkt mit 20% Glasfasern wurde für 45 Minuten bei 23°C in Methanol behandelt, in dem pro Liter 17 g Kaliumhydroxid gelöst waren. Nach dem Spülen in Wasser folgte eine Behandlung in einer alkalischen, netzmittelhaltigen Reinigerlösung. Im Anschluß wurde die Platte gespült und mit einem alkalischen Palladiumaktivator auf Basis einer Komplexverbindung mit 2-Aminopyridin (pH-Wert 10,5) bei 23°C für 5 Minuten aktiviert, nochmals gespült und danach in einer wässrigen Lösung von Dimethylaminboran die absorbierten Palladiumionen zu Palladiummetall reduziert.

Ohne zu spülen wurde die Platte in ein chemisches Kupferbad getaucht und mit ca. 0,4 µm chemisch Kupfer metallisiert. Die so an der Oberfläche leitfähige Kunststoffplatte wurde nach dem Spülen, bei 100°C im Trockenofen für 1 Stunde getempert.

Die erkaltete Platte wurde dann in einem sauren galvanischen Elektrolyten mit ca. 35 µm Kupfer verstärkt.

Mißt man jetzt die Haftung (Schältest nach DIN) des Metallüberzugs, erhält man 20–30 N/25 mm Abzugsstreifen, die sich nach einem weiteren Temperschritt bei 130°C noch auf 35–45 N/25 µm verstärkt.

Den Schocktest im Lötbad, bei dem die metallisierte Platte für 5 Sekunden in ein 260°C warmes Lötzinnbad getaucht wird, überstand der Prüfling ohne Blasenbildung und ohne wesentlichen Verlust an Haftung.

BEISPIEL 2

Eine weitere Platte aus Polyetherimid wurde nach Beispiel 1 vorbehandelt und dann mit 0,2 µm chemisch Nickel überzogen. Die Metallisierung mit galvanisch Kupfer erfolgte ebenso. Die gemessene Haftung betrug 18–17N/25 mm Abzugsstreifen, und steigerte sich nach dem Temperprozess bei 130°C auf 37–43 N/25 mm.

Den Lötbadschocktest überstand die Platte ebenfalls ohne Schädigung.

BEISPIEL 3

20 g Kaliumhydroxid (85%ig) wurden in 1 Liter Ethylenglycolmonomether gelöst. Eine Platte aus Polyetherimid wurde 5 Minuten lang bei 23°C eingetaucht und nach dem Spülen in Wasser wie in Beispiel 1 weiter behandelt.

Die Haftung nach dem Verstärken im galvanischen Kupferbad betrug 27–35 N/25 mm Abzugsstreifen, und stieg nach dem Tempern bei 130°C auf 40–47 N/25 mm.

Den Lötschocktest überstand die Platte ohne Beanstandung.

BEISPIEL 4

Eine Platte aus Polyetherimid wurde in einem reinen Methanol behandelt, welches kein Alkalihydroxid enthielt. nach 5 Minuten Tauchzeit bei 23°C wurde die Platte nach dem Spülen in Wasser in gleicher Weise wie in Beispiel 1 weiter bearbeitet.

Die Haftung betrug 1–5 N/25 mm und steigerte sich nicht mehr nach dem Tempern bei 130°C, der Lötschocktest wurde nicht überstanden, es bildeten sich Blasen und die Kupferschicht delaminierte vom Substrat.

BEISPIEL 5

10 g Natriumhydroxid werden in 1 Liter 1-Methylpyrrolidon gelöst. In dieser Lösung wurde eine Polyetherimidplatte für 5 Minuten bei 23°C getaucht und nach dem Spülen in Wasser in gleicher Weise wie in Beispiel 1 beschrieben weiter bearbeitet.

Die Haftung betrug 20–24 N/25 mm nach dem Tempern bei 130°C. Der Lötschocktest wurde überstanden.

BEISPIEL 6

300 g Natriumhydroxid wurden in Wasser aufgelöst. In dieser Lösung wurde bei 50°C eine Polyetherimidplattefür 5 Minuten getaucht. Nach dem Spülen konnte Benetzung der Oberfläche festgestellt werden. Die Platte wurde dennoch wie in Beispiel 1 weiter bearbeitet.

Es erfolgte keine zusammenhängende Metallisierung im chemischen Kupferbad, das heißt nur kleine Flecken Kupfer hatten sich auf der Oberfläche abgeschieden, so daß eine galvanische Verstärkung nicht möglich war.

Die Haftung des chemischen Kupfers war sehr gering, man konnte es mit einem Tesafilm abziehen (Tesatest).

Wurde statt des chemischen Kupferbades ein chemisches Nickelbad genommen, so unterblieb die Abscheidung von Metall gänzlich.

## Patentansprüche

1. Verfahren zur haftfesten Metallisierung von Polyetherimid durch Vorbehandlung des Polyetherimids und anschließende Aktivierung sowie chemische und gegebenenfalls galvanische Metallabscheidung, dadurch gekennzeichnet, daß das Polyetherimid mit einer Lösung bestehend aus einem alkalihydroxidhaltigen organischen Lösungsmittel, gegebenenfalls Wasser enthaltend, vorbehandelt wird.
2. Verfahren gemäß Anspruch 1, dadurch gekennzeichnet, daß als Alkalihydroxid Natriumhydroxid, Kaliumhydroxid oder Lithiumhydroxid verwendet wird.
3. Verfahren gemäß Anspruch 1, dadurch gekennzeichnet, daß als organisches Lösungsmittel ein Alkohol, ein Keton, ein Keton, ein Ether, ein Ester, ein mehrwertiger Alkohol, ein Ester eines mehrwertigen Alkohols, ein aromatischer Alkohol, ein aromatisches Keton, ein aromatischer Ester, ein heterocyclisches organisches Lösungsmittel oder deren Mischungen verwendet wird.
4. Verfahren gemäß Anspruch 1, dadurch gekennzeichnet, daß das organische Lösungsmittel in Mischung mit Wasser verwendet wird.
5. Verfahren gemäß Anspruch 1, dadurch gekennzeichnet, daß das organische Lösungsmittel 0,05 g bis 50 g/l Alkalihydroxid enthält.
6. Verfahren gemäß Anspruch 1, dadurch gekennzeichnet, daß das Polyetherimid nach erfolgter Vorbehandlung durch einen alkalischen Palladiumaktivator aktiviert wird.
7. Verfahren gemäß Anspruch 6, dadurch gekennzeichnet, daß der Palladiumaktivator komplex gebundene Palladiumionen enthält.
8. Verfahren gemäß Anspruch 7, dadurch gekennzeichnet, daß die Konzentration an Palladiumionen 0,005 g bis 10 g/l beträgt.
9. Verfahren gemäß Anspruch 1, dadurch gekennzeichnet, daß das Polyetherimid nach erfolgter Vorbehandlung und Aktivierung in üblicher Weise chemisch metallisiert wird.

## Claims

1. Method for adhesive metalplating of polyetherimide by pretreatment of the polyether imide and subsequent activation as well as chemical deposition and, possibly, electrodeposition of the metal, characterized in that the polyether imide is pretreated with a solution consisting of a hydroxide-containing organic solvent, possibly containing water.
2. Method in accordance with Claim 1, characterized in that the alkali hydroxide used is sodium hydroxide, potassium hydroxide or lithium hydroxide.
3. Method in accordande with Claim 1, characterized in that the organic solvent used is an alcohol, a ketone, an ether, an ester, a polyhydric alcohol, an ester of a polyhydric alcohol, an aromatic alcohol, an aromatic ketone, an aromatic ester, a heterocyclic organic solvent or a mixture of the same.
4. Method in accordande with Claim 1, characterized in that the organic solvent is used mixed with water.
5. Method in accordance with Claim 1, characterized in that the organic solvent contains 0.05 to 50 g/l of an alkali hydroxide.
6. Method in accordance with Claim 1, characterized in that the poly etherimide is activated after pretreatment with a palladium activator.
7. Method in accordance with Claim 6, characterized in that the palladium activator contains complexed palladium ions.
8. Method in accordance with Claim 7, characterized in that the palladium ions are present in a concentration of between 0.005 and 10 g/l.
9. Method in accordance with Claim 1, characterized in that the polyether imide is chemically metallized in the common way after pretreatment and activation.

## Revendications

1. Procédé pour la métallisation adhérente de polyétherimide par prétraitement du polyétherimide suivie d'une activation et d'une déposition chimique et, le cas échéant, électroytique du métal, caractérisé en ce que le polyétherimide est prétraité par une solution constituée d'un solvant organique hydroxyde alcalin, contenant, le cas échéant, de l'eau.
2. Procédé selon la revendication 1, caractérisé en ce que l'hydroxyde alcalin utilisé est de l'hydroxyde de sodium, de l'hydroxyde de potassium ou de l'hydroxyde de lithium.

3. Procédé selon la revendication 1, caractérisé en ce que le solvant organique utilisé est un alcool, un cétone, un éther, un ester, un alcool polyvalent, un ester d'un alcool polyvalent, un alcool aromatique, un cétone aromatique, un ester aromatique, un solvant organique hétérocyclique ou un mélange de ces derniers.

4. Procédé selon la revendication 1, caractérisé en ce que le solvant organique et utilisé mélangé à de l'eau.

5. Procédé selon la revendication 1, caractérisé en ce que le solvant organique contient 0,05 à 50 g/l d'hydroxyde alcalin.

6. Procédé selon la revendication 1, caractérisé en ce que le polyétherimide est activé par un activateur alcalin au palladium une fois le prétraitement effectué.

7. Procédé selon la revendication 6, caractérisé en ce que l'activateur au palladium contient des ions de palladium complexés.

8. Procédé selon la revendication 7, caractérisé en ce que la concentration en ions de palladium est comprise entre 0,005 et 10 g/l.

9. Procédé selon la revendication 1, caractérisé en ce que le polyétherimide est métallisé chimiquement de manière usuelle une fois le prétraitement et l'activation effectués.